# EUROPÄISCHE PATENTANMELDUNG

(11) **EP 0 807 835 A2**
(43) Veröffentlichungstag der Anmeldung: **19.11.1997**
(21) Anmeldenummer: 97401048.0
(22) Anmeldetag: 09.05.1997
(51) Int. Cl.: G02B 6/12

(54) **Monolithisch integriertes optisches Halbleiterbauelement**

(30) Priorität: 15.05.1996 DE 19619533
(71) Anmelder: ALCATEL ALSTHOM COMPAGNIE GENERALE D'ELECTRICITE, 75008 Paris (FR)
(72) Erfinder: Schilling, Michael, 70499 Stuttgart (DE); Laube, Gert, 70439 Stuttgart (DE)
(74) Vertreter: Schätzle, Albin, Dipl.-Phys.

(57) **Zusammenfassung**

Monolithisch integrierte optische Halbleiterbauelemente mit vergrabenem Streifenwellenleiter (BRS) werden in der optischen Nachrichtenübertragung eingesetzt. Sie enthalten aktive (AB) und passive (PB) Wellenleiterbereiche. Bei passiven Wellenleiterbereichen mit vergrabenem Streifenwellenleiter treten hohe Absorbtionsverluste auf, wogegen es bei passiven Wellenleiterbereichen mit verlustarmen Rippenwellenleitern zu Reflexionen und Streuverlusten an der Stoßstelle zu aktiven Wellenleiterbereichen kommt.

Ein erfindungsgemäßes Halbleiterbauelement (BE2) besitzt in aktiven (AB) wie in passiven (PB) Wellenleiterbereichen einen vergrabenen Streifenwellenleiter (BRS), der von einer Deckschicht (DS) bedeckt ist. Zusätzlich befindet sich in den passiven Bereichen (PB) zwischen Streifenwellenleiter (BRS) und Deckschicht (DS) eine semiisolierende oder undotierte Mantelschicht (MS).

Desweiteren ist auch ein Verfahren angegeben, nach dem ein erfindungsgemäßes Halbleiterbauelement hergestellt werden kann.

## Beschreibung

Die Erfindung betrifft ein monolithisch integriertes optisches Halbleiterbauelement gemäß dem Oberbegriff des Anspruchs 1 und ein Herstellungsverfahren gemäß dem Oberbegriff des Anspruchs 8.

Ein solches Halbleiterbauelement wird zur Signalerzeugung, Signalregeneration, Signalverarbeitung oder zum Schalten von Signalen in der optischen Nachrichtenübertragung eingesetzt, insbesondere in optischen Übertragungsnetzen, die weitgehend ohne optoelektronische Signalwandlung arbeiten. Dazu sind in dem Halbleiterbauelement aktive Wellenleiterbereiche wie z.B. Laser, Schalter, Modulatoren, Verstärker oder Detektoren mit passiven Wellenleiterbereichen wie z.B. passiven Wellenleitern, Verzweigern, Filtern oder Kopplern monolithisch integriert.

Ein Laser mit vergrabenem Streifenwellenleiter, der mit einem passiven Wellenleiter monolithisch integriert ist, ist bekannt aus einem Artikel von D. Remiens et al (Buried Ridge Stripe Lasers Monolithically Integrated with Butt-Coupled Passive Waveguides for OEIC, SPIE Vol. 1362, S. 323-330). Bei dem passiven Wellenleiter handelt es sich ebenfalls um einen vergrabenen Streifenwellenleiter, der von einer p-dotierten Deckschicht überdeckt ist. Nachteilhaft sind jedoch hohe Absorptionsverluste im passiven Wellenleiter. Zudem ist der Laser nach einem Verfahren hergestellt, welches mehrere Schritte enthält, die eine genaue Justierung des Lasers auf Lithographiemasken erfordern.

Desweiteren ist aus der Veröffentlichung der Europäischen Patentanmeldung EP 616 243 A ein monolithisch integriertes optisches Halbleiterbauelement mit aktiven und passiven Wellenleiterbereichen bekannt. Es ist dort ein kaskadierter optischer Raumschalter beschrieben, der sowohl in den aktiven als auch in den passiven Wellenleiterbereichen einen Streifenwellenleiter hat. Desweiteren ist ein Verfahren angegeben, mit dem dieser Streifenwellenleiter in einem einzigen Beschichtungsprozeß aufgebracht werden kann. Eine Deckschicht ist in EP 616 243 A nicht beschrieben.

Im Stand der Technik werden in monolithisch integrierten Halbleiterbauelementen für viele Anwendungen bevorzugt vergrabene Streifenwellenleiter in den aktiven Wellenleiterbereichen eingesetzt. Wie z.B. aus U. Koren et al, Semi-Insulating Blocked Planar BH GaInAsP/InP Laser with High Power and High Modulation Bandwidth, Elektr. Lett. Vol. 24 No. 3 1988, bekannt, eignet sich diese Wellenleiterstruktur aufgrund des niedrigen Schwellenstromes, der hohen erreichbaren Ausgangsleistung und der langen Lebensdauer vor allem für Laser, aber auch für integrierte Verstärker und Schalter wird sie eingesetzt. Dagegen werden, wie z.B. aus T. Koch et al, Semiconductor Photonic Integrated Circuits, IEEE J. Quant. Elektr. Vol. 27 No. 3 1991, bekannt, in den passiven Wellenleiterbereichen aufgrund ihrer niedrigen Absorptionsverluste bevorzugt Rippenwellenleiter eingesetzt. Die Integration verschiedener Wellenleiterstrukturen führt aber zu technologisch aufwendigen Herstellungsverfahren und zudem treten an den Stoßstellen zwischen aktiven und passiven Wellenleiterbereichen mit unterschiedlichen Wellenleiterstrukturen Streuverluste und Reflexionen auf.

Es ist daher Aufgabe der Erfindung, ein monolithisch integriertes optisches Halbleiterbauelement mit niedrigeren Absorptionsverlusten anzugeben, welches in aktiven und passiven Wellenleiterbereichen die gleiche Wellenleiterstruktur hat.

Desweiteren ist es Aufgabe der Erfindung, ein Verfahren zur Herstellung eines solchen Halbleiterbauelementes anzugeben.

Die Aufgabe wird hinsichtlich des Bauelementes durch die Merkmale des Patentanspruchs 1 und hinsichtlich des Verfahrens durch die Merkmale des Patentanspruchs 8 gelöst. Vorteilhafte Ausgestaltungen sind den abhängigen Patentansprüchen zu entnehmen.

Das erfindungsgemäße Bauelement weist zudem den Vorteil auf, daß die passiven Wellenleiterbereiche durch die Mantelschicht isoliert werden, da der Übergang von p-dotierten zu n-dotierten Halbleiterschichten unterbrochen ist und somit keine parasitären Ströme durch die passiven Wellenleiterbereiche fließen können. Dies führt zu verbesserten Hochfrequenzeigenschaften des Halbleiterbauelementes, d.h. zu einem erweiterten Frequenzgang.

Anhand der Figuren 1 bis 7 sollen nachfolgend zwei Ausführungsbeispiele eines erfindungsgemäßen Halbleiterbauelementes sowie ein Verfahren zur Herstellung eines solchen Halbleiterbauelementes beschrieben werden. Es zeigen:
- Fig. 1: einen Schnitt durch ein Halbleiterbauelement in einem ersten Ausführungsbeispiel der Erfindung entlang des vergrabenen Streifenwellenleiters,
- Fig. 2a und Fig. 2b: einen Schnitt durch das Halbleiterbauelement des ersten Ausführungsbeispiels senkrecht zu dem vergrabenen Streifenwellenleiter im aktiven Wellenleiterbereich und im passiven Wellenleiterbereich,
- Fig. 3 bis Fig. 7: eine schematische räumliche Ansicht eines Halbleiterbauelementes in einem zweiten Ausführungsbeispiel der Erfindung nach verschiedenen Schritten eines Herstellungsverfahrens.

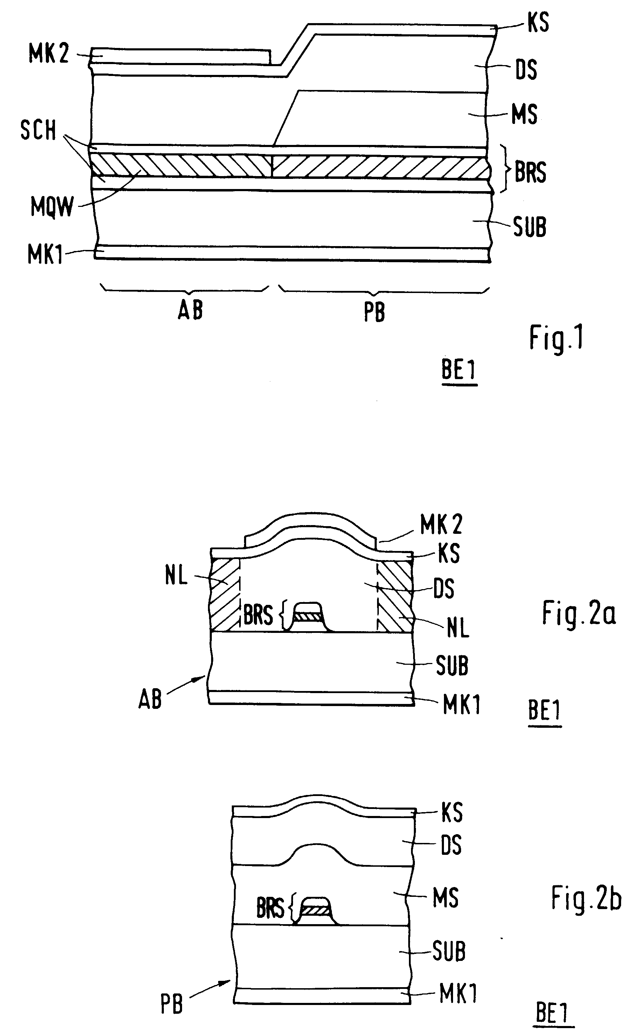

In Figur 1 ist ein Schnitt durch ein erstes Ausführungsbeispiel eines erfindungsgemäßen optischen Halbleiterbauelementes BE1 gezeigt. Der Schnitt verläuft entlang eines im optischen Halbleiterbauelement BE1 vergrabenen Streifenwellenleiters BRS.

Das optische Halbleiterbauelement BE1 hat ein Substrat SUB, dem der Streifenwellenleiter BRS aufliegt. Dieser Streifenwellenleiter BRS hat einen aktiven, d.h. gesteuert lichtverstärkenden oder lichtabsorbierenden Wellenleiterbereich AB und einen passiven, d.h. Licht unverstärkt weiterleitenden Wellenleiterbereich PB. Im passiven Wellenleiterbereich PB ist der Streifenwellenleiter von einer Mantelschicht MS überdeckt.

Das Halbleiterbauelement BE1 ist ganzflächig von einer Deckschicht DS und einer Kontaktschicht KS bedeckt. Im aktiven Wellenleiterbereich AB befindet sich zudem ein Metallkontakt MK2 über dem Streifenwellenleiter BRS auf der Kontaktschicht KS. Die Unterseite des Substrates SUB ist ganzflächig mit einer Metallkontaktschicht MK1 beschichtet.

Der vergrabene Streifenwellenleiter BRS enthält wenigstens eine optisch aktive Schicht MQW. Vorzugsweise handelt es sich bei dieser wenigstens einen optisch aktiven Schicht MQW um eine Multi-Quantumwell-Struktur, d.i. ein Schichtenstapel, der Halbleiterschichten mit abwechselnd einer kleinen und einer großen Bandabstandsenergie enthält. Mit Bandabstandsenergie ist der energetische Abstand zwischen Valenz- und Leitungsband eines Halbleiters bezeichnet. In einer solchen Multi-Quantumwell-Struktur sind für Ladungsträger (Elektronen und Löcher) nur diskrete Übergänge möglich, deren Übergangsenergie im folgenden mit Energiebandlücke bezeichnet ist.

Die Dicke dieser Halbleiterschichten bestimmt die größe der Energiebandlücke und damit die Wellenlänge bei der Licht im Streifenwellenleiter BRS absorbiert, verstärkt oder emittiert wird. Die Wellenlänge, bei der Licht in dem aktiven Wellenleiterbereich gesteuert verstärkt oder absorbiert wird, wird als Arbeitswellenlänge λ bezeichnet. In dem Fall das der Streifenwellenleiter BRS nur eine optisch aktive Schicht enthält, wird die Arbeitswellenlänge durch die Materialzusammensetzung dieser Schicht bestimmt.

In dem ersten Ausführungsbeispiel ist das Halbleiterbauelement BE1 durch geeignete Wahl der Schichtdicken der Halbleiterschichten mit der kleinen und der mit der großen Bandabstandsenergie für Lichtsignale einer Arbeitswellenlänge λ von 1550 nm ausgelegt. Üblicherweise liegt für Nachrichtenübertragung über weite Strecken die Arbeitswellenlänge λ in einem Bereich von 1530 nm bis 1580 nm.

In dem passiven Wellenleiterbereich PB ist die Energiebandlücke größer oder kleiner als in dem aktiven Wellenleiterbereich AB. Dadurch wird Licht der Arbeitswellenlänge λ in dem passiven Wellenleiterbereich PB kaum oder zumindest weniger stark, als dies bei gleicher Energiebandlücke der Fall wäre, absorbiert. Um den Unterschied in der Energiebandlücke anzudeuten ist in Figur 1 die wenigstens eine optisch aktive Schicht MQW in dem aktiven Wellenleiterbereich AB anders schraffiert als in dem passiven PB.

Desweiteren enthält der Streifenwellenleiter BRS Wellenleiterschichten SCH, die die wenigstens eine optisch aktive Schicht MQW in Richtung senkrecht zur Substratebene einschließen. Diese Wellenleiterschichten SCH weisen einen Brechungsindex auf, der größer ist als der Brechungsindex des umgebenden Halbleitermaterials von Deckschicht DS, Mantel schicht MS und Substrat SUB. Dadurch wird eine Lichtwelle in dem vergrabenen Streifenwellenleiter BRS geführt.

Die Deckschicht DS weist für Lichtsignale der Arbeitswellenlänge λ einen Absorptionskoeffizienten auf. Dieser Absorptionskoeffizient gibt an, wie stark eine Lichtwelle in dem Material auf einer bestimmten Strecke durch Absorption abgeschwächt wird.

Die Mantelschicht MS weist einen Absorptionskoeffizient auf, der kleiner ist als der Absorptionskoeffizient der Deckschicht DS. D.h. eine Lichtwelle wird im Material der Mantelschicht MS auf einer gleichen Strecke weniger stark durch Absorption abgeschwächt als im Material der Deckschicht DS.

Wird in dem Streifenwellenleiter BRS eine Lichtwelle geführt, so breiten sich gewisse Anteile dieser Lichtwelle auch in dem Material aus, welches den Streifenwellenleiter umgibt, d.h. im Material des Substrates SUB, der Deckschicht DS oder der Mantelschicht MS. In dem passiven Wellenleiterbereich PB ist der Streifenwellenleiter BRS von der Mantelschicht überdeckt, die einen kleineren Absorptionskoeffizient aufweist als die Deckschicht DS, welche den Streifenwellenleiter in dem aktiven Wellenleiterbereich AB überdeckt. Dadurch sind Absorptionsverluste in dem passiven Wellenleiterbereich verringert.

Wie erläutert ist es die Aufgabe der Mantelschicht MS, Absorptionsverluste im passiven Wellenleiterbereich PB zu verringern. Diese Absorptionsverluste rühren vor allem von Intervalenzbandübergängen in p-dotiertem Halbleitermaterial, aus dem im Ausführungsbeispiel die Deckschicht DS besteht. Zur Verringerung dieser Verluste besteht die Mantelschicht MS aus undotiertem oder semiisolierendem Halbleitermaterial. Semiisolierendes Halbleitermaterial zeichnet sich dadurch aus, daß es Rekombinationsstellen für strahlungslose Übergänge aufweist, so daß freie Ladungsträger (Elektronen und Löcher) an diesen Rekombinationsstellen rekombinieren, bevor sie mit einer Lichtwelle in Wechselwirkung treten können. Ein Beispiel für solches semiisolierendes Halbleitermaterial ist Fe- oder Cr-dotiertes InP.

Da durch eine semiisolierende oder undotierte Halbleiterschicht nahezu kein Strom fließen kann, ist eine Mantelschicht MS aus solchem Halbleitermaterial nur im passiven Wellenleiterbereich PB über dem Streifenwellenleiter BRS aufgebracht. Im aktiven Wellenleiterbereich AB liegt dem Streifenwellenleiter BRS direkt die Deckschicht DS auf, die eine Dotierung vom entgegengesetzten Leitungstyp hat wie das Substrat SUB. Im Ausführungsbeispiel ist das Substrat n-dotiert.

In einer besonders vorteilhaften Ausgestaltung ist der Brechungsindex der Mantel schicht MS gleich groß wie der Brechungsindex der Deckschicht DS. Zwischen dem aktiven Wellenleiterbereich AB und dem passiven Wellenleiterbereich PB herrscht dann keine Änderung des Brechungsindexes im Halbleitermaterial, welches den vergrabenen Streifenwellenleiter BRS umgibt. Dadurch sind die Eigenschaften der Lichtwellenführung des vergrabenen Streifenwellenleiters BRS im aktiven AB und passiven PB Wellenleiterbereich gleich und es treten keine Streuverluste und Reflexionen auf.

In einer weiteren vorteilhaften Ausgestaltung besteht der Streifenwellenleiter BRS sowohl im aktiven AB wie auch im passiven PB Wellenleiterbereich aus einem durchgehenden, zusammenhängenden Halbleiterschichtpaket, welches in einem einzigen Beschichtungsprozeß aufgebracht ist. Am Übergang zwischen aktivem AB und passivem PB Wellenleiterbereich besteht in dieser Ausgestaltung im Streifenwellenleiter BRS keine Stoßstelle, an der verschiedene Halbleiterschichten in Lichtausbreitungsrichtung aneinander gesetzt sind. Dadurch werden ebenfalls Streuverluste und Reflexionen vermieden.

Eine weitere vorteilhafte Ausgestaltung besteht darin, daß der Streifenwellenleiter BRS ein Halbleiterschichtpaket mit einer Multi-Quantumwell-Struktur MQW besitzt und aus einem durchgehenden, zusammenhängenden Halbleiterschichtpaket besteht, wobei die Halbleiterschichten der Multi-Quantumwell-Schichten MQW in dem aktiven Wellenleiterbereich AB eine größere Schichtdicke aufweisen als in den passiven PB. Die Schichtdicke dieser Halbleiterschichten bestimmt die Energiebandlücke der Multi-Quantumwell-Struktur und damit die Wellenlänge bei der Licht absorbiert, emittiert oder verstärkt wird.

In dieser vorteilhaften Ausgestaltung liegt die Energiebandlücke der Multi-Quantumwell-Struktur MQW im aktiven Wellenleiterbereich AB bei 1550 nm und im passiven PB bei 1430 nm. Dadurch werden Absorptionsverluste für Licht der Arbeitswellenlänge λ = 1550 nm im passiven Wellenleiterbereich PB vermieden.

In Figur 2a und 2b ist dasselbe optische Halbleiterbauelement BE1 dargestellt wie in der Figur 1. Dabei zeigt Figur 2a einen Schnitt senkrecht zu dem Streifenwellenleiter BRS in dem aktiven Wellenleiterbereich AB und Figur 2b einen Schnitt senkrecht zu dem Streifenwellenleiter BRS in dem passiven Wellenleiterbereich PB. In dem in Figur 2a gezeigten aktiven Wellenleiterbereich AB ist der mesaförmige Streifenwellenleiter BRS zu sehen, der dem Substrat SUB aufliegt und von der Deckschicht DS vollständig überdeckt ist. Die Bereiche NL der Deckschicht DS auf beiden Seiten des Streifenwellenleiters BRS sind z.B. durch Ionenimplantation, vorzugsweise Implantation von Protonen, nichtleitend gemacht, damit ein Betriebsstrom auf den Bereich des Streifenwellenleiters BRS beschränkt ist. Auf der Deckschicht DS befindet sich eine hochdotierte Kontaktschicht KS und ein Metallkontakt MK2, der über dem Streifenwellenleiter BRS auf die Kontaktschicht KS aufgebracht ist.

In dem in Figur 2b gezeigten passiven Wellenleiterbereich PB befindet sich zusätzlich zwischen Deckschicht DS und Streifenwellenleiter BRS die Mantelschicht MS. Nichtleitende Bereiche in der Deckschicht DS sowie ein Metallkontakt auf der Kontaktschicht KS sind in dem passiven Wellenleiterbereich PB nicht vorgesehen.

Im ersten Ausführungsbeispiel bestehen das Substrat SUB aus n-dotiertem InP, die Deckschicht DS aus p-dotiertem InP, die Kontaktschicht aus p⁺-dotiertem (hochdotiertem) InGaAsP und die Wellenleiter- und Multi-Quantumwell-Schichten aus ternären oder quaternären Mischkristallen vom III/V-Verbindungstyp wie z.B. InGaAsP, InGaAs, InGaAlAs oder ähnlichen. Die Mantelschicht MS ist aus undotiertem oder semiisolierendem InP.

Als Material für das Halbleiterbauelement eignen sich aber auch andere Halbleiter vom III/V-Verbindungstyp wie GaAs. Mögliche Materialien sind auch Halbleiter vom II/VI- oder IV/IV-Verbindungstyp.

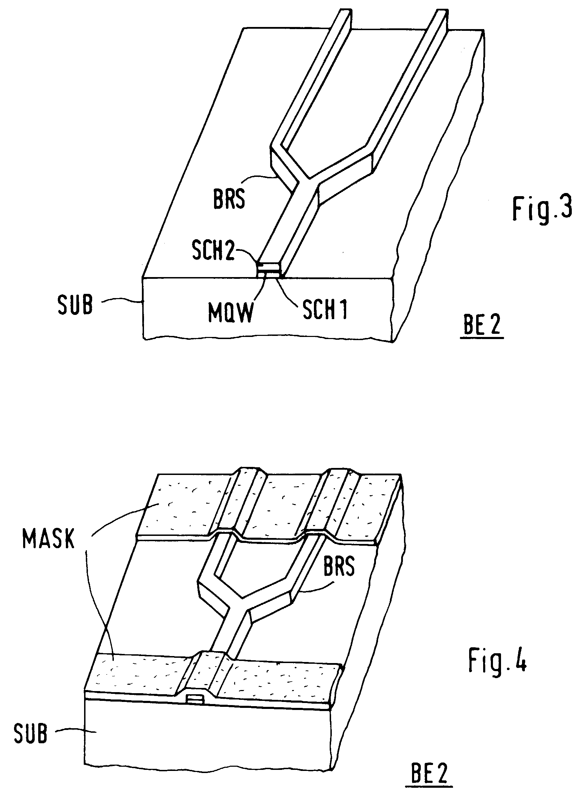

In den Figuren 3 bis 7 ist schematisch ein zweites Ausführungsbeispiel eines erfindungsgemäßen Halbleiterbauelementes BE2 nach verschiedenen Schritten eines erfindungsgemäßen Herstellungsverfahrens dargestellt. Figur 3 zeigt ein Substrat SUB, auf das in einem ersten Schritt ein mesastreifenförmiger Streifenwellenleiter BRS aufgebracht wurde. In dem zweiten Ausführungsbeispiel bildet der Streifenwellenleiter BRS eine Y-förmige Verzweigung.

Bei einer vorteilhaften Ausführung des ersten Schrittes wird in einem ersten Teilschritt auf das Substrat SUB ganzflächig ein Halbleiterschichtpaket aufgebracht. Dieses Halbleiterschichtpaket besteht im Ausführungsbeispiel aus einer ersten Wellenleiterschicht SCH1, einem optisch aktiven Schichtpaket mit Multi-Quantumwell-Struktur MQW und einer zweiten Wellenleiterschicht SCH2. Das Aufbringen des Halbleiterschichtpaketes kann durch epitaktisches Abscheiden von Halbleitermaterial aus der flüssigen Phase (LPE) oder aus der Gasphase (MOVPE) geschehen.

Besonders vorteilhaft ist es auch, das Halbleiterschichtpaket mittels Molekülstrahlepitaxie mit dem Gas-Source-Molecular-Beam-Epitaxy-Verfahren (GSMBE) aufzubringen, da sich bei diesem Verfahren die Schichtdicken und damit die Energiebandlücke der Multi-Quantumwell-Struktur über eine große Beschichtungsfläche, wie z.B. die Fläche eines Wafers mit 2 Zoll Durchmesser, gut kontrollieren lassen.

Im zweiten Teilschritt werden aus dem Halbleiterschichtpaket aktive und passive Wellenleiterbereiche gebildet, und zwar so, daß die Energiebandlücke in den aktiven Wellenleiterbereichen eine andere ist als in den passiven.

Eine Möglichkeit dazu, ist das als Quantumwell-Intermixing bekannte Verfahren. Dabei werden in dem zweiten Teilschritt die als passive Wellenleiterbereiche vorgesehenen Teile des Halbleiterschichtpaketes mit Ionen beschossen, wodurch Gitterdefekte erzeugt werden. Anschließend wird das Halbleiterbauelement BE2 erhitzt und getempert, wodurch die Gitterdefekte großteils wieder ausheilen. Durch diese Behandlung wird die Energiebandlücke der Multi-Quantumwell-Struktur zu kürzeren Wellenlängen verschoben. Der so gebildete Streifenwellenleiter BRS ist ein durchgehender, zusammenhängender Teil des Halbleiterschichtpaketes. Es bestehen dadurch im fertigen Halbleiterbauelement BE2 keine Stoßstellen zwischen aktiven und passiven Wellenleiterbereichen an denen in Lichtausbreitungsrichtung verschiedene Halbleiterschichten im Streifenwellenleiter aneinandergesetzt sind. Dadurch werden Reflexionen und Streuverluste vermieden.

Eine andere Möglichkeit bietet das als Butt-Coupling bekannte Verfahren. Dabei werden in dem zweiten Teilschritt z.B. die als passiven Wellenleiterbereiche vorgesehenen Teile des Halbleiterschichtpaketes entfernt und durch selektives Aufwachsen durch ein neues Schichtpaket mit anderer Energiebandlücke ersetzt.

In einem dritten Teilschritt wird mittels Photolithographie eine Ätzmaske auf dem Halbleiterschichtpaket hergestellt. Die Ätzmaske besteht aus Photolack und deckt die Bereiche des Halbleiterschichtpaketes ab, aus denen der Streifenwellenleiter BRS gebildet wird. In einem vierten Teilschritt wird das Halbleiterschichtpaket geätzt, so daß ein mesaförmiger Streifen als Streifenwellenleiter BRS auf dem Substrat SUB bleibt. Das kann z.B. durch chemisches Naßätzen mit einem Ätzmittel geschehen. Dabei werden die von der Ätzmaske bedeckten Bereiche des Halbleiterschichtpaketes durch das Ätzmittel nicht abgelöst. In einem fünften Teilschritt wird anschließend die Ätzmaske mit einem Lösungsmittel wieder entfernt.

Eine weitere besonders vorteilhafte Ausführung des ersten Schrittes enthält die folgenden Teilschritte. In einem ersten Teilschritt wird eine dielektrische Maske auf das Substrat SUB aufgebracht, z.B. aus SiO₂. Diese dielektrische Maske ist mittels Photolithographie und Ätzen z.B. mit gepufferter Fluß-Säure so strukturiert, daß schmale Streifen, in denen der Streifenwellenleiter gebildet werden soll, frei bleiben. In aktiven Wellenleiterbereichen ist der schmale Streifen von großflächig maskierten Bereichen seitlich begrenzt. In passiven Wellenleiterbereichen fehlt eine seitliche Begrenzung durch die dielektrische Maske oder es besteht eine nur schmale dielektrische, seitliche Maskierung.

In einem zweiten Teilschritt wird ein Halbleiterschichtpaket aufgebracht, welches eine erste Wellenleiterschicht SCH1, ein Schichtpaket mit Multi-Quantumwell-Struktur MQW und eine zweite Wellenleiterschicht SCH2 enthält. Dazu wird das Metall-Organic Vapor-Phase Epitaxie (MOVPE) Verfahren verwendet, bei dem Halbleitermaterial aus der Gasphase abgeschieden wird. Vorzugsweise geschieht dies bei einem Druck von 100-150 mbar. Auf der dielektrischen Maske scheidet sich kein Halbleitermaterial ab. Migration und Diffusion in der Gasphase direkt oberhalb der dielektrischen Maske erhöhen die Aufwachsgeschwindigkeit auf benachbarten, unmaskierten Bereichen der Substratoberfläche. Halbleiterschichten in den aktiven Bereichen, die großflächig von einer dielektrischen Maske seitlich begrenzt sind, wachsen daher dicker auf als Halbleiterschichten in passiven Bereichen, die nicht oder nur von einer schmalen dielektrischen Maske seitlich begrenzt sind. In einem dritten Teilschritt wird die dielektrische Maske z.B. mit gepufferter Fluß-Säure wieder entfernt.

Das so gebildete Halbleiterschichtpaket besteht aus Halbleiterschichten, die in den aktiven Wellenleiterbereichen eine größere Schichtdicke aufweisen als in den passiven Wellenleiterbereichen. Die Energiebandlücke der Multi-Quantumwell-Struktur MQW beträgt dadurch im zweiten Ausführungsbeispiel 1550 nm in den aktiven Wellenleiterbereichen und 1430 nm in den passiven Wellenleiterbereichen. Aus dem Halbleiterschichtpaket kann nun durch Ätzen unter Verwendung einer Ätzmaske aus Photolack der Streifenwellenleiter BRS gebildet werden.

In einem zweiten Schritt des Herstellungsverfahrens wird eine dielektrische Schicht MASK auf das Halbleiterbauelement BE2 aufgebracht und photolithographisch so strukturiert, daß sie die als aktive Bereiche vorgesehenen Teile des Streifenwellenleiters einschließlich der daran angrenzenden Teile der Substratoberfläche abdeckt. Dabei kann, wie in Figur 4 dargestellt, die abgedeckte Fläche um ein Vielfaches größer sein, als die Breite des Streifenwellenleiters BRS. Die dielektrische Schicht MASK kann z.B. aus SiO₂ oder SiN sein. In Figur 4 ist das Halbleiterbauelement BE2 nach diesem zweiten Schritt dargestellt.

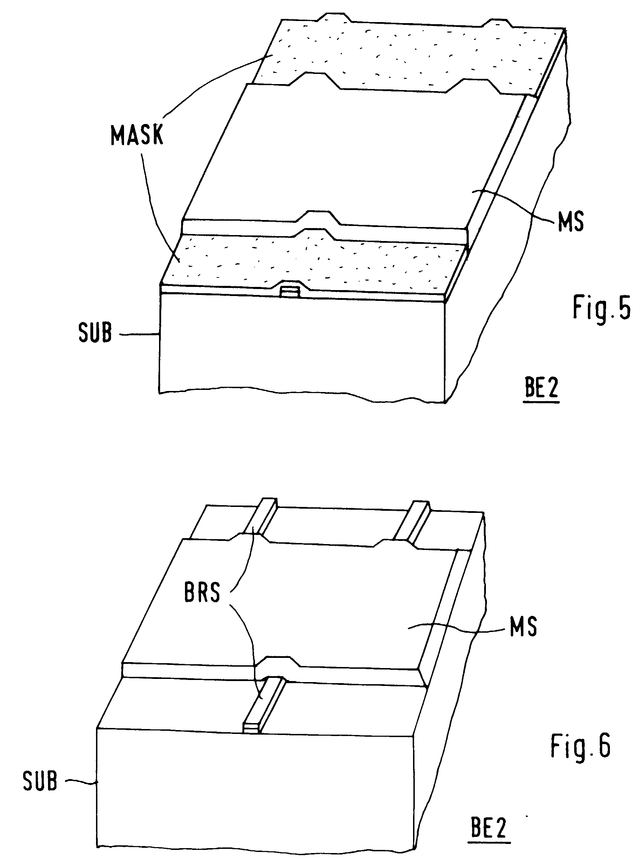

In einem dritten Schritt wird eine Mantelschicht MS aufgebracht. Diese Mantelschicht ist aus undotiertem oder semiisolierendem Halbleitermaterial. Besonders geeignet ist dafür epitaktisches Abscheiden aus der Gasphase nach dem MOVPE-Verfahren, aber auch Flüssigphasen (LPE) oder Molekülstrahlepitaxie (GSMBE) eignen sich zum Abscheiden der Mantelschicht MS. Auf der dielektrischen Schicht MASK wird dabei kein oder nur polikristallines Halbleitermaterial abgeschieden, so daß nur die passiven Wellenleiterbereiche von der Mantelschicht MS überdeckt werden. Das Halbleiterbauelement BE2 nach diesem dritten Schritt ist in Figur 5 gezeigt.

In einem vierten Schritt wird nun die dielektrische Schicht MASK einschließlich darauf eventuell vorhandener Ablagerungen wieder entfernt. Besteht die dielektrische Schicht MASK beispielsweise aus SiO₂, so kann dazu gepufferte Flußsäure verwendet werden, welche SiO₂ selektiv ablöst. Durch diesen Schritt wird der Streifenwellenleiter BRS in den aktiven Bereichen wieder freigelegt. Figur 6 zeigt das Halbleiterbauelement BE2 nach diesem vierten Schritt.

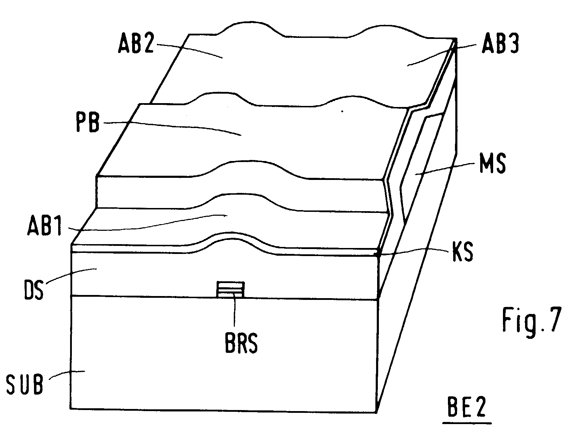

In einem fünften Schritt wird nun ganzflächig eine Deckschicht DS und eine Kontaktschicht KS aufgebracht. Das kann z.B. durch epitaktisches Abscheiden von Halbleitermaterial aus der Flüssigphase (LPE) oder aus der Gasphase (MOVPE) oder mittels Molekülstrahlepitaxie (GSMBE) geschehen. Deckschicht DS und Kontaktschicht KS besitzen eine Dotierung vom umgekehrten Leitungstyp wie das Substrat SUB. Der Streifenwellenleiter BRS ist sowohl in den aktiven Wellenleiterbereichen AB1 - AB3 wie auch in den passiven Wellenleiterbereichen PB vollständig von der Deckschicht DS bedeckt und in den passiven Wellenleiterbereichen PB befindet sich zwischen Streifenwellenleiter BRS und Deckschicht DS zusätzlich die Mantelschicht MS. In Figur 7 ist das Halbleiterbauelement BE2 nach diesem fünften Schritt gezeigt.

In einem weiteren Schritt können die Bereiche der Deckschicht DS auf beiden Seiten des Streifenwellenleiters BRS durch Implantation vom Ionen, vorzugsweise Protonen, nichtleitend gemacht werden. Dadurch wird ein Betriebsstrom auf den Bereich des Streifenwellenleiters BRS beschränkt und der Strombedarf sinkt. Bei einem Laser wird durch diesen Schritt beispielsweise die Quantenausbeute erhöht.

In einem abschließenden Schritt wird in den aktiven Wellenleiterbereichen AB1 - AB3 oberhalb des Streifenwellenleiters BRS ein Metallkontakt auf die Kontaktschicht KS aufgebracht.

Das Halbleiterbauelement BE2 im zweiten Ausführungsbeispiel enthält einen ersten aktiven Wellenleiterbereich AB1, der sich in einem passiven Wellenleiterbereich PB mit einer y-förmigen Verzweigung in zwei Teilwellenleiter teilt. Die beiden Teilwellenleiter besitzen je einen weiteren aktiven Wellenleiterbereich AB2, AB3. Eine solche Anordnung dient z.B. als Element für einen kaskadierten optischen Raumschalter, wie er in EP 616 243 A angegeben ist. Ein Lichtsignal, welches in den ersten aktiven Wellenleiterbereich AB1 eingestrahlt wird, kann wahlweise in einen oder beide Teilwellenleiter weitergeleitet werden. Der erste aktive Wellenleiterbereich AB1 dient dabei als Eingangsverstärker und die beiden weiteren aktiven Wellenleiterbereiche AB2, AB3 dienen als Schalter und können entweder lichtdurchlässig oder lichtundurchlässig gesteuert werden. Durch Zusammenschalten einer Vielzahl solcher Halbleiterbauelemente BE2 auf einem gemeinsamen Substrat kann ein kaskadierter optischer Raumschalter gebildet werden.

## Patentansprüche

1. Monolithisch integriertes optisches Halbleiterbauelement (BE1, BE2), welches für Lichtsignale einer Arbeitswellenlänge (λ) ausgelegt ist, mit
- einem Substrat (SUB),
- einem optischen Wellenleiter (BRS), der auf diesem Substrat (SUB) angeordnet ist und
- einer dotierten Deckschicht (DS), die für Lichtsignale der Arbeitswellenlänge (λ) einen Absorptionskoeffizient aufweist,
bei dem der optische Wellenleiter (BRS)
- einen aktiven, gesteuert lichtverstärkenden oder lichtabsorbierenden (AB, AB1, AB2, AB3) und einen passiven, Licht unverstärkt weiterleitenden (PB) Wellenleiterbereich hat und
- sowohl im aktiven (AB, AB1, AB2, AB3) wie auch im passiven (PB) Wellenleiterbereich ein vergrabener Streifenwellenleiter ist,
**dadurch gekennzeichnet**, daß
- der optische Wellenleiter (BRS) in dem passiven Wellenleiterbereich (PB) von einer Mantelschicht (MS) überdeckt ist,
- die Mantelschicht (MS) einen Absorptionskoeffizienten für Lichtsignale der Arbeitswellenlänge (λ) aufweist, der kleiner ist als der Absorptionskoeffizient der Deckschicht (DS) und daß
- die Mantelschicht (MS) in dem passiven Wellenleiterbereich (PB) von der Deckschicht (DS) überdeckt ist.

2. Optisches Halbleiterbauelement (BE1, BE2) gemäß Anspruch 1, dadurch gekennzeichnet, daß die Mantelschicht (MS) aus semiisolierendem oder aus undotiertem Halbleitermaterial besteht.

3. Optisches Halbleiterbauelement (BE1, BE2) gemäß Anspruch 1 oder 2, dadurch gekennzeichnet, daß der Brechungsindex der Mantelschicht (MS) gleichgroß ist wie der Brechungsindex der Deckschicht (DS).

4. Optisches Halbleiterbauelement (BE1, BE2) gemäß einem der Ansprüche 1 bis 3, dadurch gekennzeichnet, daß der optische Wellenleiter (BRS) ein durchgehend zusammenhängender Teil eines flächig aufgebrachten Halbleiterschichtpaketes ist.

5. Optisches Halbleiterbauelement (BE1, BE2) gemäß einem der Ansprüche 1 bis 4, dadurch gekennzeichnet, daß der optische Wellenleiter (BRS) ein Halbleiterschichtpaket (MQW) mit einer Multi-Quantumwell-Struktur besitzt.

6. Optisches Halbleiterbauelement (BE1, BE2) gemäß Anspruch 5, dadurch gekennzeichnet, daß die Schichtdicke von Schichten des Halbleiterschichtpaketes mit Multi-Quantumwell-Struktur (MQW) in dem aktiven Wellenleiterbereich (AB, AB1, AB2, AB3) größer ist als in dem passiven Wellenleiterbereich (PB).

7. Optisches Halbleiterbauelement (BE1, BE2) gemäß einem der Ansprüche 1 bis 6, dadurch gekennzeichnet, daß das Substrat (SUB) aus n-dotiertem InP, die Deckschicht (DS) aus p-dotiertem InP bestehen und der optische Wellenleiter ternäre oder quaternäre Schichten aus Mischkristallen vom III/V-Verbindungstyp enthält.

8. Verfahren zur Herstellung eines optischen Halbleiterbauelementes (BE1, BE2) mit einem vergrabenen Streifenwellenleiter (BRS), der aktive, gesteuert lichtverstärkende oder lichtabsorbierende (AB, AB1, AB2, AB3) und passive, Licht unverstärkt weiterleitende (PB) Wellenleiterbereiche hat, welches folgende Schritte aufweist:
a) Aufbringen eines zu einem Streifenwellenleiter (BRS) strukturierten Halbleiterschichtpaketes auf ein Substrat (SUB),
b) ganzflächiges Aufbringen einer Deckschicht (DS) und einer Kontaktschicht (KS) und
c) Aufbringen eines Metallkontaktes (MK2) auf die Kontaktschicht in den aktiven Wellenleiterbereichen (AB, AB1, AB2, AB3),
dadurch gekennzeichnet, daß zwischen den Schritten a) und b) folgende Schritte ausgeführt werden:
i) Abdecken der aktiven Wellenleiterbereiche (AB, AB1, AB2, AB3) mit einer dielektrischen Schicht (MASK),
ii) Abscheiden einer Mantelschicht (MS) aus semiisolierendem oder undotiertem Halbleitermaterial und
iii) Entfernen der dielektrischen Schicht (MASK).

9. Verfahren gemäß Anspruch 8, dadurch gekennzeichnet, daß das Aufbringen des zu einem Streifenwellenleiter strukturierten Halbleiterschichtpaketes folgende Teilschritte enthält:
a) ganzflächiges Aufbringen des Halbleiterschichtpaketes auf das Substrat (SUB),
b) Bilden von aktiven und passiven Wellenleiterbereichen aus dem Halbleiterschichtpaket,
c) photolithographisches Aufbringen einer Ätzmaske, welche die Bereiche des Streifenwellenleiters (BRS) abdeckt,
d) Ätzen des Halbleiterschichtpaketes und
e) Entfernen der Ätzmaske.

10. Verfahren gemäß Anspruch 8, dadurch gekennzeichnet, daß das Aufbringen des zu einem Streifenwellenleiter strukturierten Halbleiterschichtpaketes folgende Teilschritte enthält:
a) Aufbringen einer dielektrischen Maske, welche mittels Photolithographie und Ätzen so strukturiert ist, daß sie die Bereiche des Streifenwellenleiters (BRS) beidseitig begrenzt diese Bereiche aber nicht bedeckt und daß diese die Bereiche des Streifenwellenleiters (BRS) beidseitig begrenzende Maske in den aktiven Wellenleiterbereichen (AB, AB1, AB2, AB3) breiter ist als in den passiven (PB),
b) Aufbringen des Halbleiterschichtpaketes durch Abscheidung von Halbleitermaterial aus der Gasphase und
c) Entfernen der dielektrischen Maske.
